# EUROPEAN PATENT SPECIFICATION

(11) **EP 2 071 634 B1**
(45) Date of publication and mention of the grant of the patent: **01.06.2016**
(21) Application number: 07123172.4
(22) Date of filing: 13.12.2007
(51) Int. Cl.: H01L 31/054

(54) **Method for aligning a lens array to a solar cell array**
Verfahren zur Ausrichtung einer Linsenanordnung an einer Solarzellenanordnung
Procédé pour l'alignement d'un réseau de lentilles sur un réseau de cellules solaires

(43) Date of publication of application: 17.06.2009
(73) Proprietor: Atomic Energy Council - Institute of Nuclear Energy Research, Lungtan, Taoyuan, Taiwan (TW)
(72) Inventor: Shin, Hwa-Yuh, 333, CHIAAN VILLAGE, LUNGTAN, TAOYUAN (TW); Kuo, Hung-Zen, 333, CHIAAN VILLAGE, LUNGTAN, TAOYUAN (TW); Chiu, Hung-Sheng, 333, CHIAAN VILLAGE, LUNGTAN, TAOYUAN (TW)
(74) Representative: Beck & Rössig European Patent Attorneys

(56) References cited:
- DE-B1- 2 757 765
- JP-A- 9 148 610
- JP-A- 10 190 036
- US-A1- 2005 081 908
- US-A1- 2007 095 385

## Description

### BACKGROUND OF INVENTION

### 1. FIELD OF INVENTION

The present invention relates to a method for aligning a lens array to a cell array of a concentration photovoltaic module.

### 2. RELATED PRIOR ART

A concentration photovoltaic module includes lenses to focus sunlight onto solar cells that are made of a small area and a high photoelectric conversion coefficient. Because the sunlight is concentrated into light beams, only a small amount of solar cells are needed for generating a considerable amount of electricity. Therefore, the concentration photovoltaic module can efficiently generate electricity at a low cost.

Generally, alignment of the lenses of a concentration photovoltaic module to the solar cells depends on a spot-type light source. The sun is an appropriate spot-type light source. However, the intensity of the sunlight and the weather are not under our control. The alignment of the lenses to the solar cells is often affected by the weather and cannot be done smoothly.

The present invention is therefore intended to obviate or at least alleviate the problems encountered in prior art.

A concentration photovoltaic module is known from JP 10190036. It comprises a plurality of solar cells on a support plate disposed in a casing. It further comprises a plurality of concentration leuses which are arranged on a lid body of the housing. The support plate can be moved in the housing so as to follow the position of the sun while the lid body is kept fixed on the housing.

### SUMMARY OF INVENTION

It is an objective of the present invention to improve alignment of a lens array to a cell array of a concentration photovoltaic module.

This problem is solved by the method according to claim 1. Advantageous embodiments are laid down in further claims.

To achieve the foregoing objective, the lens array is made with lenses and alignment windows while the cell array is made with solar cells and alignment points. A collimation module is made with collimated light sources. The concentration photovoltaic module is located under the collimation module so that the alignment windows are located under the collimated light sources. The collimated light sources are used to emit collimated light beams and cast the collimated light beams onto the cell array through the alignment windows. The lens array is moved relative to the cell array so that the collimated light beams are directed to the alignment points. Hence, light beams emitted from the lenses are directed to the solar cells.

Other objectives, advantages and features of the present invention will become apparent from the following description referring to the attached drawings.

### BRIEF DESCRIPTION OF DRAWINGS

The present invention will be described via detailed illustration of the preferred embodiment referring to the drawings.
Fig. 1 is a flowchart of a method for aligning a lens array to a cell array according to the preferred embodiment of the present invention.
Fig. 2 is a top view of a collimation module for use in the method shown in Fig. 1.
Fig. 3 is a top view of a lens array for use in the method shown in Fig. 1.
Fig. 4 is a top view of a cell array for use in the method shown in Fig. 1.
Fig. 5 is an exploded view of the collimation module shown in Fig. 2 and a concentration photovoltaic module including the lenses shown in Fig. 3 and the solar cells shown in Fig. 4.
Fig. 6 shows the operation of aligning the lens array to the cell array shown in Fig. 5.

### DETAILED DESCRIPTION OF PREFERRED EMBODIMENT

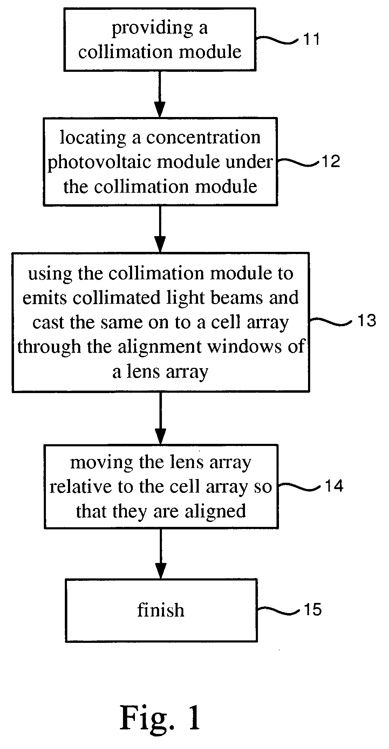

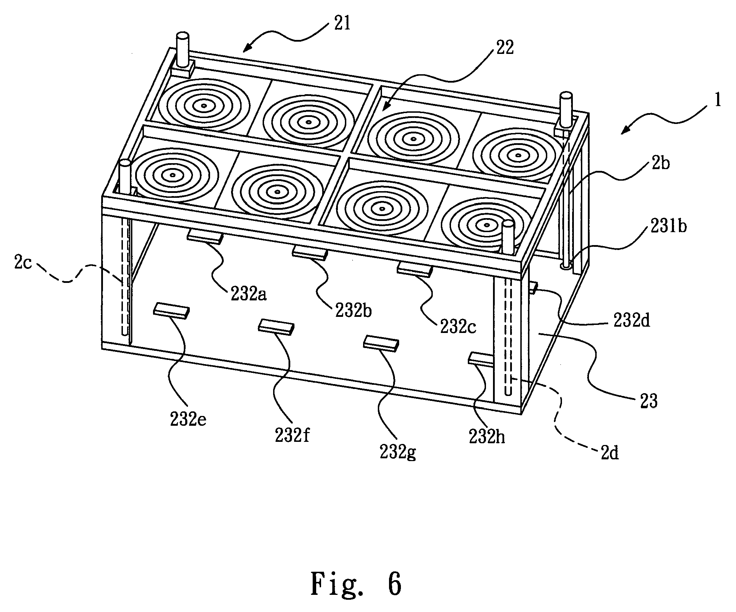

Referring to Fig. 1, there is shown a method for aligning a lens array 22 to a cell array 23 of a concentration photovoltaic module 1 (Fig. 6).

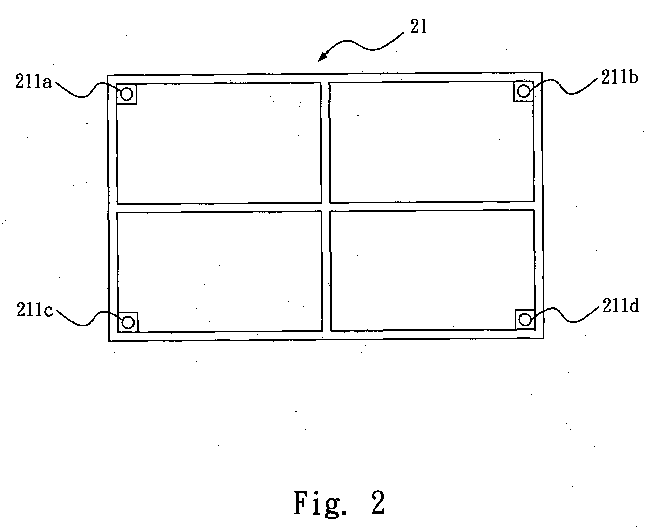

Referring to Figs. 1 and 2, at 11, a collimation module 21 is provided. The collimation unit 2 includes a plurality of collimated light sources 211a, 211b, 211c and 211d.

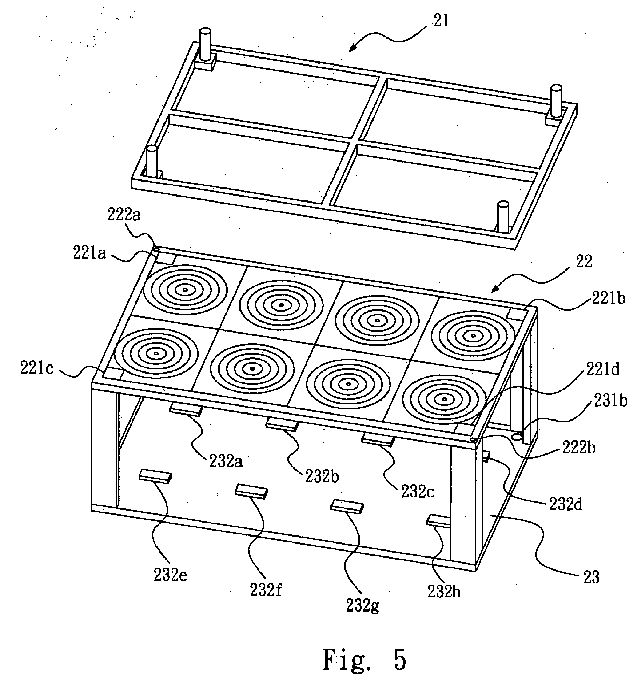

Referring to Figs. 1, 5, and 6 at 12, the concentration photovoltaic module 1 is located under the collimation unit 21.

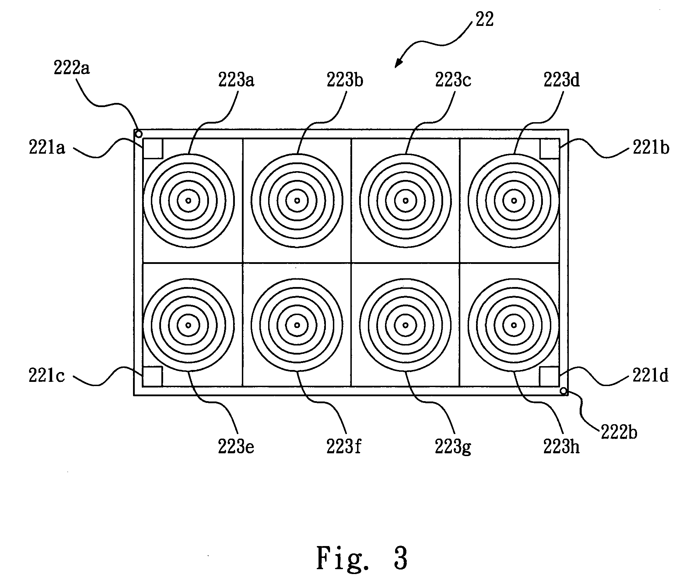

Referring to Fig. 3, the lens array 22 includes a plurality of alignment windows 221 a, 221b, 221c and 221d, a plurality of alignment apertures 222a and 222b and a plurality of concentration lenses 223a, 223b, 223c, 223d, 223e, 223f, 223g and 223h. The lens array 22 is attached to the bottom of the collimation module 21 so that they are movable together and that the alignment windows 221a to 221d are aligned to the collimated light sources 211a to 211 d.

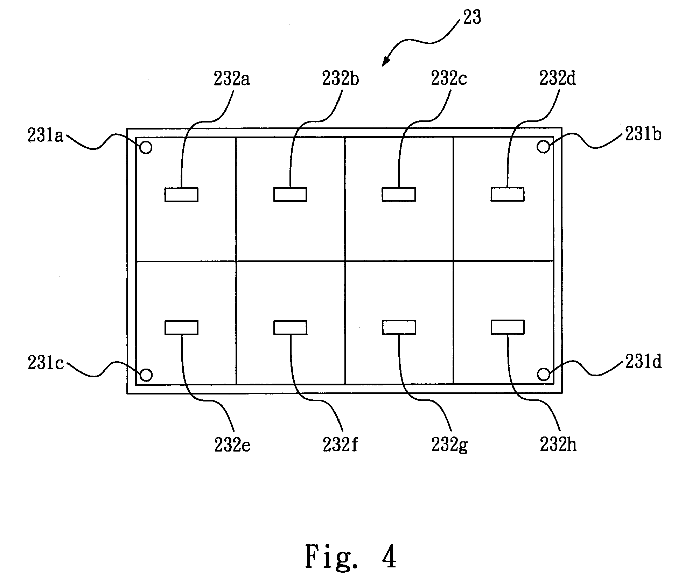

Referring to Fig. 4, the cell array 23 includes a plurality of alignment points 231a, 231b, 231c and 231d and a plurality of solar cells 232a, 232b, 232c, 232d, 232e, 232f, 232g and 232h. The alignment points 231a to 231d are located near the corners of the cell array 23. The cell array 23 is located under the lens array 22 so that the alignment points 231 a to 231 d are located under the alignment windows 221a to 221d and that they are movable together with each other.

At 13, the collimation module 21 emits collimated light beams 2a, 2b, 2c and 2d (Fig. 6). The collimated light beams 2a to 2d are preferably laser. The collimated light beams 2a to 2d are cast onto the cell array 23 through the alignment windows 221a to 221d of the lens array 22.

At 14, the lens array 22 is horizontally moved relative to the cell array 23, i.e., the lens array 22 or the cell array 23 is horizontally moved, so that the collimated light beams 2a to 2d are cast on the alignment points 231a to 231d through the alignment windows 221a to 221 d.

Referring to Figs. 1 and 6, at 15, the collimation module 21 collimates the sunlight and casts the collimated light on the lens array 22. The concentration lenses 223a to 223h of the lens array 22 concentrate the collimated light into a plurality of light spots and cast the light spots on the solar cells 232a to 232h of the cell array 23.

As discussed above, optical alignment is used in the present invention. Referring to Figs. 1 and 2, at 11, the collimation module 21 is provided. The collimated light sources 211a, 211b, 211c and 211 d of the collimation unit 21 cast collimated light beams 2a to 2d onto the alignment points 231a to 231d of the cell array 23 through the alignment windows 221a to 221d of the lens array 22. The lens array 22 or the cell array 23 is moved so that the alignment windows 221a to 221d are aligned to the alignment points 231a to 231d. Therefore, the axes of the light beams emitted from the concentration lenses 223a to 223h of the lens array 22 are aligned to the centers of the solar cells 232a to 232h of the cell array 23.

The optical alignment is conducted without having to complicate the structure of the concentration photovoltaic module 1. Therefore, the method according to the present invention enables the concentration photovoltaic module 1 to efficiently generate electricity at a low cost.

The present invention has been described via the detailed illustration of the preferred embodiment. Those skilled in the art can derive variations from the preferred embodiment without departing from the scope of the present invention. Therefore, the preferred embodiment shall not limit the scope of the present invention defined in the claims.

## Claims

1. A method for aligning a lens array (22) to a cell array (23) of a concentration photovoltaic module (1), wherein the lens array (22) comprises a plurality of concentration lenses (223a to 223h) and alignment windows (221a to 221d), and the cell array (23) comprises a plurality of solar cells (232a to 232h) and alignment points (231a, 231b, 231c and 231d), said method comprising the steps of:
- providing at least one collimation module (21) comprising collimated light sources (211a, 211b, 211c and 211d) to emit collimated light beams;
- attaching the lens array (22) to the bottom of the collimation module (21) so that the alignment windows (221a to 221d) of the lens array (22) are located under the collimated light sources (211 a, 211b, 211c and 211d);
- locating the cell array (23) under the lens array (22) so that the alignment points of the cell array (231a, 231b, 231c, 231d) are located under the alignment windows (221a to 221d) of the lens array
- casting the collimated light beams of said collimated light sources (211a, 211b, 211c and 211d) onto the cell array (23) through the alignment windows (221a to 221d) of the lens array (22); and
- adjusting the relative position between the lens array (22) and the cell array (23) so that the collimated light beams, which are passing through the alignment windows (221a to 221 d) of the lens array (22), are directed to the alignment points (231a, 231 b, 231c and 231d) of the cell array (23) resulting in that the axes of the light beams emitted from the concentration lenses (223a to 223h) of the lens array (22) are directed to the centers of the solar cells (232a to 232h) of the cell array (23).

2. The method according to claim 1, wherein the alignment points (231a, 231b, 231c and 231d) are located near the corners of the cell array (23).

3. The method according to claim 1 or 2, wherein the collimated light sources emit laser light (211a, 211b, 211c and 211d).

## Patentansprüche

1. Verfahren zur Ausrichtung einer Linsenanordnung (22) zu einer Zellenanordnung (23) eines konzentrierenden Photovoltaikmoduls (1), wobei die Linsenanordnung (22) eine Vielzahl von Konzentrationslinsen (223a bis 223h) und Ausrichtungsfenstern (221a bis 221d) umfasst, und wobei die Zellenanordnung (23) eine Vielzahl von Solarzellen (232a bis 232h) und Ausrichtungspunkten (231a, 231b, 231c und 231d) umfasst, wobei das Verfahren folgende Schritte umfasst:
- Bereitstellen von mindestens einem Kollimationsmodul (21), das kollimierte Lichtquellen (211a, 211b, 211c und 211d) umfasst, um kollimierte Lichtstrahlen zu emittieren;
- Befestigen der Linsenanordnung (22) an dem Boden des Kollimationsmoduls (21), so dass die Ausrichtungsfenster (221a bis 221b) der Linsenanordnung (22) unter den kollimierten Lichtquellen (211a, 211b, 211c und 211b) angeordnet sind;
- Anordnen der Zellenanordnung (23) unter der Linsenanordnung (22), so dass die Ausrichtungspunkte der Zellenanordnung (231a, 231b, 231c, 231b) unter den Ausrichtungsfenstern (221a bis 221b) der Linsenanordnung angeordnet sind;
- Werfen der kollimierten Lichtstrahlen der kollimierten Lichtquellen (211a, 211b, 211c und 211 d) auf die Zellenanordnung (23) durch die Ausrichtungsfenster (221a bis 221 d) der Linsenanordnung (22); und
- Ausrichten der relativen Position zwischen der Linsenanordnung (22) und der Zellenanordnung (23), so dass die kollimierten Lichtstrahlen, die durch die Ausrichtungsfenster (221a bis 221b) der Linsenanordnung (22) verlaufen, auf die Ausrichtungspunkte (231a, 231b, 231c und 231b) der Zellenanordnung (23) gerichtet sind, was dazu führt, dass die Achsen der von den Konzentrationslinsen (223a bis 223h) der Linsenanordnung (22) emittierten Lichtstrahlen auf die Zentren der Solarzellen (232a bis 232h) der Zellenanordnung (23) gerichtet sind.

2. Verfahren nach Anspruch 1, wobei die Ausrichtungspunkte (231a, 231b, 231c und 231d) nahe den Ecken der Zellenanordnung (23) angeordnet sind.

3. Verfahren nach Anspruch 1 oder 2, wobei die kollimierten Lichtquellen Laserlicht (211a, 211b, 211c und 211 d) emittieren.

## Revendications

1. Procédé pour aligner un réseau de lentilles (22) sur un réseau de cellules (23) d'un module photovoltaïque de concentration (1), le réseau de lentilles (22) comprenant une pluralité de lentilles de concentration (223a à 223h) et de fenêtres d'alignement (221a à 221d) et le réseau de cellules (23) comprenant une pluralité de cellules solaires (232a à 232h) et de points d'alignement (231a, 231b, 231c et 231d), ledit procédé comprenant les étapes de :
- fourniture d'au moins un module de collimation (21) comprenant des sources de lumière collimatée (211a, 211b, 211c et 211d) pour émettre des faisceaux de lumière collimatée,
- de fixation du réseau de lentilles (22) au fond du module de collimation (21) de telle manière que les fenêtres d'alignement (221 à 221d) du réseau de lentilles (22) soient situées en dessous des sources de lumière collimatée (211a, 211b, 211c et 211d) ;
- localisation du réseau de cellules (23) en dessous du réseau de lentilles (22) si bien que les points d'alignement du réseau de cellules (231a, 231b, 231c et 231d) soient situés en dessous des fenêtres d'alignement (221a à 221d) du réseau de lentilles ;
- coulage des faisceaux de lumière des sources de lumière collimatée (211a, 211b, 211c et 211d) sur le réseau de cellules (23) par les fenêtres d'alignement (221a à 221d) du réseau de lentilles (22) et
- ajustage de la position relative entre le réseau de lentilles (22) et le réseau de cellules (23) si bien que les faisceaux de lumière collimatée qui traversent les fenêtres d'alignement (221a à 221d) du réseau de lentilles (22) sont dirigés sur les points d'alignement (231a, 231b, 231c et 231d) du réseau de lentilles (23), ce qui résulte en ce que les axes des faisceaux de lumière émis par les lentilles de concentration (223a à 2223h) du réseau de lentilles (22) sont dirigés sur les centres des cellules solaires (232a à 232h) du réseau de cellules (23).

2. Procédé selon la revendication 1, les points d'alignement (231a, 231b, 231c et 231d) étant situés près des coins du réseau de cellules (23).

3. Procédé selon la revendication 1 ou 2, les sources de lumière collimatée émettant une lumière laser (211 a, 211b, 211c et 211 d).
